# DEMANDE DE BREVET EUROPEEN

(11) **EP 0 987 751 A1**
(43) Date de publication de la demande: **22.03.2000**
(21) Numéro de dépôt: 99410113.7
(22) Date de dépôt: 14.09.1999
(51) Int. Cl.: H01L 21/761, H01L 27/08

(54) **Mur d'isolement entre composants de puissance**

(30) Priorité: 16.09.1998 FR 9811714
(71) Demandeur: STMicroelectronics S.A., 94250 Gentilly (FR)
(72) Inventeur: Duclos, Franck, 37000 Tours (FR)
(74) Mandataire: de Beaumont, Michel

(57) **Abrégé**

L'invention concerne un mur d'isolement du deuxième type de conductivité destiné à séparer des composants élémentaires formés dans des caissons différents d'une tranche semi-conductrice d'un premier type de conductivité, un composant situé dans l'un au moins des caissons étant susceptible de fonctionner avec une densité de courant importante. Le mur d'isolement comporte au moins deux murs d'isolement élémentaires (63, 64) séparés par une portion (65) du matériau de la tranche et, en fonctionnement, cette portion est connectée à un potentiel de référence.

## Description

La présente invention concerne les composants semiconducteurs de puissance, c'est-à-dire des composants susceptibles de commuter des courants importants et/ou de supporter des tensions élevées.

Classiquement, les composants de puissance et/ou haute tension étaient réalisés sous forme de composants discrets. Eventuellement, pour assurer l'isolement latéral de ces composants et améliorer leur tenue en tension, la périphérie des composants était constituée d'un mur d'isolement formé par diffusion profonde d'atomes dopants à partir des faces supérieure et inférieure d'une plaquette de silicium, la découpe étant formée au milieu de ce mur d'isolement.

Avec l'évolution des techniques, on en est venu à fabriquer plusieurs composants de puissance et notamment plusieurs composants verticaux dans une même puce. Des exemples de telles structures sont décrits dans la demande de brevet EP-A-0721218 de la demanderesse (inventeur R. Pezzani) qui sera considérée ici comme connue. Dans EP-A-0721218, comme dans toutes les descriptions de composants formés dans des caissons séparés par des murs d'isolement, on considère que chacun des composants formé dans un caisson entouré d'un mur d'isolement est convenablement isolé des composants adjacents qui n'influent pas les uns sur les autres.

La demanderesse a constaté dans certaines structures comprenant des composants formés dans des caissons distincts séparés par des murs d'isolement que le passage d'un courant important dans un composant pouvait affecter un composant adjacent. En conséquence, dans la demande de brevet français non publiée N° 97/06822 déposée le 28.05.1997 (inventeurs F. Duclos et F. Rami), la demanderesse a analysé le problème, distingué l'isolement "statique" de l'isolement "dynamique", et proposé une modification de la structure des murs d'isolement pour résoudre le problème.

Plus particulièrement, la demanderesse a proposé une structure de mur d'isolement qui présente un niveau de dopage supérieur à 10¹⁶ atomes/cm³ au niveau de sa partie médiane, au point de rencontre de diffusions profondes formées à partir des faces supérieure et inférieure, et a également proposé que, de préférence, la partie médiane du mur d'isolement ait une étendue latérale supérieure à la demi épaisseur de la plaquette dans laquelle sont formées les diffusions profondes.

Cette solution antérieure implique, pour une plaquette d'épaisseur donnée, d'augmenter la durée du recuit de diffusion lors de la formation des murs d'isolement et/ou d'augmenter la largeur des murs d'isolement.

Dans le cas où des courants particulièrement intenses sont amenés à circuler dans certains caissons, on en arrive, pour isoler convenablement les caissons voisins, à prévoir des largeurs de murs d'isolement supérieures à l'épaisseur de la tranche semiconductrice, c'est-à-dire que, en vue de dessus, la surface de silicium occupée par les murs d'isolement devient très importante.

La présente invention vise à prévoir une structure de mur d'isolement telle que les courants de fuite entre caissons adjacents soient particulièrement faibles.

Un autre objet de la présente invention est de prévoir une structure de mur d'isolement telle que la surface occupée par le mur d'isolement soit réduite pour des courants intenses.

Pour atteindre ces objets, la présente invention prévoit un mur d'isolement du deuxième type de conductivité destiné à séparer des composants élémentaires formés dans des caissons différents d'une tranche semiconductrice d'un premier type de conductivité, un composant situé dans l'un au moins des caissons étant susceptible de fonctionner avec une densité de courant importante. Le mur d'isolement comporte au moins deux murs d'isolement élémentaires séparés par une portion du matériau de la tranche et, en fonctionnement, cette portion est connectée à un potentiel de référence.

Selon un mode de réalisation de la présente invention, la largeur des ouvertures à partir desquelles sont formées les diffusions de dopants dans les surfaces supérieure et inférieure du substrat est inférieure à la demi-épaisseur de la tranche.

Ce mur d'isolement s'applique à séparer deux caissons contenant des triacs verticaux.

Ce mur d'isolement s'applique à séparer deux caissons dont l'un au moins comprend une diode, un thyristor ou un triac vertical.

Ce mur d'isolement s'applique à une structure dans laquelle les divers composants sont de type vertical et la puce semiconductrice comprend une métallisation unique en face arrière.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
les figures 1 à 3 représentent divers assemblages de composants et sont destinées à illustrer le problème que la présente invention vise à résoudre ;
la figure 4 représente l'allure d'un mur d'isolement selon un premier état de la technique ;
la figure 5 représente l'allure d'un mur d'isolement selon la demande de brevet français 97/06822 ;
les figures 6A et 6B représentent l'allure d'un mur d'isolement selon la présente invention ; et
la figure 7 illustre le courant de fuite d'un caisson pour divers types de murs d'isolement.

Comme cela est classique dans le domaine de la représentation des composants semiconducteurs, les diverses vues en coupe sont fortement schématiques et ne sont pas tracées à l'échelle. L'homme de l'art saura choisir les profondeurs de jonction et les dimensions latérales des composants en fonction des performances qu'il recherche.

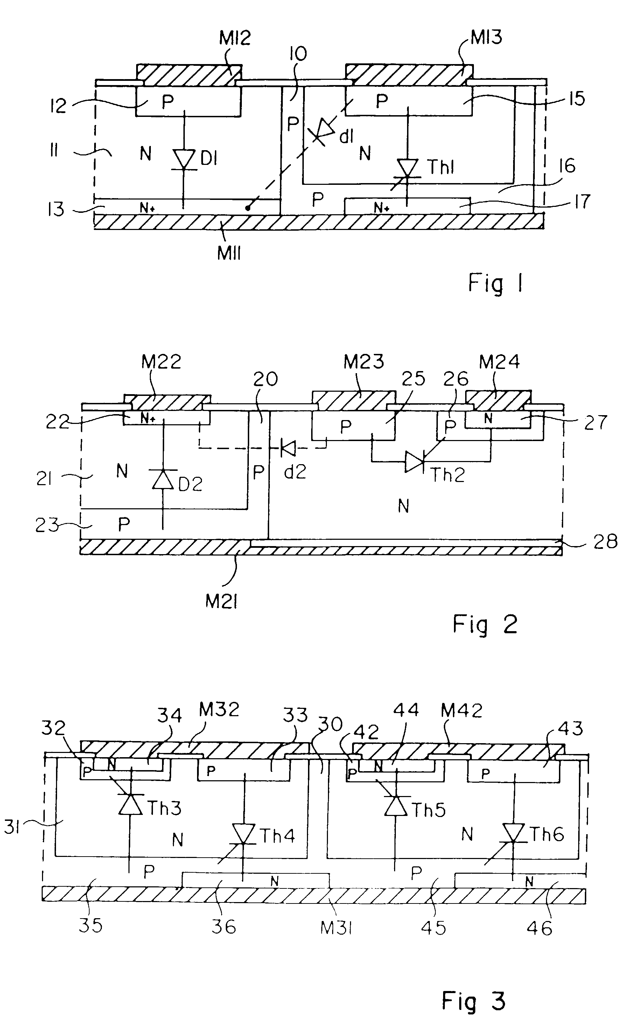

La figure 1 représente un exemple d'association d'une diode et d'un thyristor à cathode commune. Cette figure est extrêmement simplifiée et seules les parties utiles à l'exposé de l'invention ont été représentées. Notamment la structure de gâchette du thyristor n'est pas représentée.

La partie gauche de la figure 1 correspond à une diode verticale D1 et la partie droite à un thyristor vertical Th1 formé dans un caisson séparé de la partie gauche par un mur d'isolement 10 de type P. La structure est formée dans un substrat 11 de type N. La diode D1 comprend une région 12 de type P formée du côté de la face supérieure du substrat et une région 13 fortement dopée de type N du côté de la face inférieure du substrat. Le thyristor Th1 comprend une région 15 de type P formée du côté de la face supérieure du substrat, une région 16 de type P formée du côté de la face inférieure et une région 17 de type N formée dans la région 16 du côté de la face inférieure du substrat. La face inférieure de la structure est revêtue d'une métallisation de cathode M11. La région 12 est revêtue d'une métallisation M12 d'anode de la diode et la région 15 est revêtue d'une métallisation M13 d'anode du thyristor.

Le rôle classique du mur d'isolement 10 est d'éviter l'apparition de composants parasites. En effet, en l'absence de ce mur d'isolement, il existerait entre les métallisations M13 et M11 une diode PNN⁺ d1 constituée des régions 15, 11 et 13. Cette diode dl fonctionnerait dès que la métallisation M13 serait polarisée positivement par rapport à la métallisation M11 et entraînerait la mise en conduction du thyristor Th1 en l'absence de courant de gâchette. La présence du mur d'isolement 10 entraîne que le trajet dans le substrat 11 est interrompu par deux diodes en série et en inverse dont l'une est forcément bloquante.

On notera que l'effet parasite de la diode dl se produit quelle que soit la polarisation de la métallisation M12 et quel que soit le courant circulant dans la diode D1. On peut donc dire que le mur d'isolement a un effet statique d'isolement en tension.

La figure 2 représente un exemple schématique d'une structure associant une diode verticale D2 à un thyristor latéral Th2. Ces deux composants sont séparés par un mur d'isolement 20. Comme dans le cas de la figure 1, par souci de clarté, la structure a été simplifiée et notamment la gâchette du thyristor n'est pas représentée. La structure est formée dans un substrat 21 de type N. La diode D2 comprend du côté de la face supérieure une région 22 de type N et du côté de la face inférieure une région 23 de type P. Le thyristor Th2 comprend du côté de la face supérieure une région 25 de type P et une région 26 de type P dans laquelle est formée une région 27 de type N. Le caisson N dans lequel est formé le thyristor latéral est revêtu du côté de sa face inférieure d'une couche isolante 28. La face inférieure est revêtue d'une métallisation M21 d'anode de la diode. La région 22 est revêtue d'une métallisation M22 de cathode de la diode. La région 25 est revêtue d'une métallisation M23 d'anode du thyristor latéral. La région 27 est revêtue d'une métallisation M24 de cathode du thyristor.

En l'absence du mur d'isolement 20, il existerait une diode PNN⁺ d2 entre les métallisations M23 et M22 et, si l'anode M23 du thyristor est polarisée positivement par rapport à la métallisation M22, la mise en conduction de la jonction entre la région 25 et le substrat 21 entraînera le déclenchement du thyristor Th2 en l'absence de courant de gâchette.

Ici aussi, le mur d'isolement sert à éviter l'existence d'une diode parasite. A nouveau, le mur d'isolement a un effet statique de protection en tension.

La figure 3 représente schématiquement une structure associant côte à côte deux triacs séparés par un mur d'isolement 30 et formés dans un substrat 31 de type N. Le triac de gauche comprend des thyristors tête-bêche Th3 et Th4. Le triac de droite comprend des thyristors tête-bêche Th5 et Th6. Du côté gauche, sont formées du côté de la face supérieure des régions de type P 32 et 33 (représentées comme séparées par souci d'illustration mais souvent d'une seule pièce). Dans la région 32 est formée une région 34 de type N. Du côté de la face arrière, est formée une région 35 de type P et, dans cette région 35, en regard de la région 33, une région 36 de type N. Du côté droit de la figure, des régions 42 à 46 correspondent respectivement aux régions 32 à 36. On notera que les régions 35 et 45 forment en fait une seule et même couche de type P. La face arrière est revêtue d'une métallisation M31. La région de cathode du thyristor Th3 et la région d'anode du thyristor Th4 sont revêtues d'une métallisation M32. La région de cathode du thyristor Th5 et la région d'anode du thyristor Th6 sont revêtues d'une métallisation M42.

Dans cette structure, en l'absence du mur d'isolement 30, il n'existe pas comme dans le cas des figures précédentes de diodes parasites mais de très nombreux transistors parasites susceptibles d'entrer en conduction et de provoquer la conduction de l'un ou l'autre des triacs en l'absence de signal de gâchette.

Ainsi, dans le cas des trois exemples précédents, le mur d'isolement joue un rôle statique de protection en tension de composants adjacents. Jusqu'à présent, ce rôle a été considéré comme satisfaisant.

La demanderesse a constaté dans le cas de l'assemblage de triacs de la figure 3 que, bien que le fonctionnement du dispositif décrit soit satisfaisant dans toutes les configurations de tension des diverses bornes et lors des fonctionnements habituels, il survenait parfois des incidents quand le courant dans l'un des triacs dépassait un certain seuil. Des problèmes similaires ont été constatés dans les assemblages des figures 1 et 2, et d'autres. Plus particulièrement, dans le cas de la figure 1, si un courant important traverse la diode D1, un courant de fuite peut apparaître dans la structure adjacente et ce courant, s'il est suffisamment élevé, est susceptible de déclencher le thyristor Th1 ; dans le cas de la figure 2, si un courant important traverse la diode D2, le thyristor Th2 est susceptible de se déclencher ; et dans le cas de la figure 3, si un courant important parcourt le thyristor Th3, le thyristor Th5 est susceptible de se déclencher.

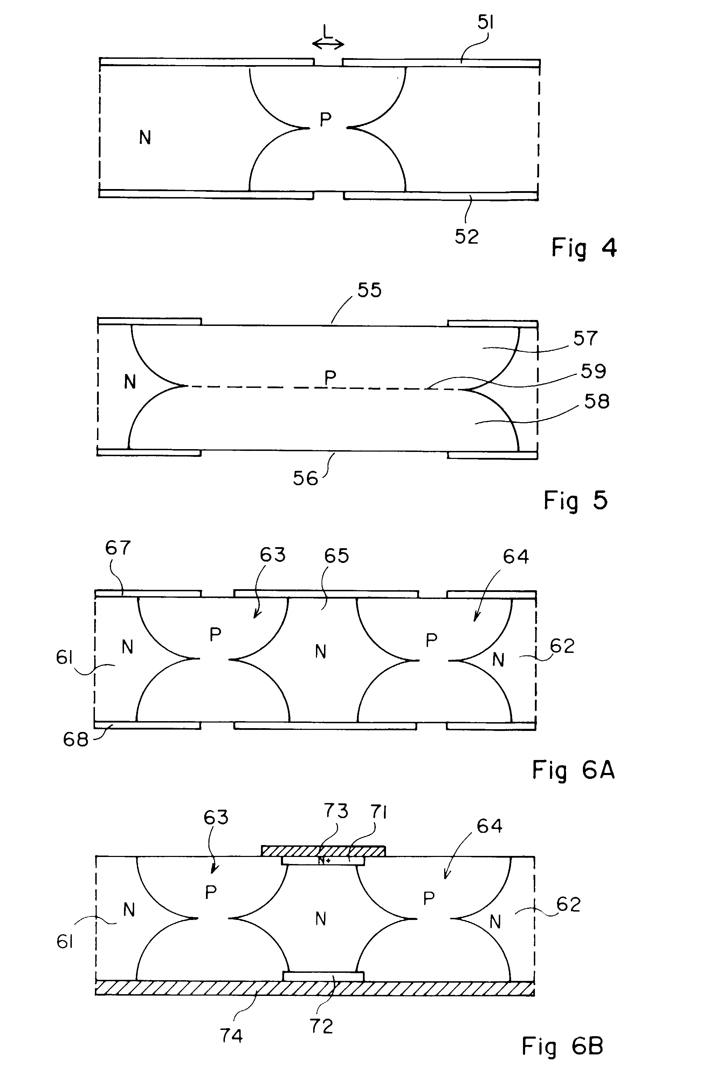

La figure 4 illustre un mur d'isolement classique. Ce mur est formé à partir de masques 51 et 52 formés sur les surfaces supérieure et inférieure d'un substrat 11, par implantation d'un dopant de type P et recuit, ou par recuit sous atmosphère dopante. Dans les deux cas, si la plaquette de silicium a une épaisseur de l'ordre de 200 à 300 µm, il faut procéder à un recuit très long, par exemple de plusieurs centaines d'heures, pour que les dopants s'étendant par diffusion à partir des surfaces inférieure et supérieure se rejoignent. Bien entendu, le niveau de dopage en surface est très supérieur au niveau de dopage à l'endroit où les diffusions supérieure et inférieure se rejoignent, c'est-à-dire dans la partie médiane du mur d'isolement. Pour ne pas augmenter indûment la durée de l'étape de diffusion, on s'arrête généralement dès que les deux diffusions se rejoignent et ce d'autant plus que rien n'incitait à prolonger cette étape. Alors, la concentration de dopant au niveau de la partie médiane est généralement relativement faible, par exemple de l'ordre de 10¹⁵ atomes/cm³. La largeur du mur d'isolement dans cette partie médiane est alors sensiblement égale à la largeur L des ouvertures dans les masques. De plus, dans l'art antérieur, on souhaite habituellement réduire autant que possible la dimension des murs d'isolement. Ainsi, la largeur L est généralement choisie aussi petite que possible.

La demande de brevet français 97/06822 expose que, dès que la densité de courant dans un caisson dépasse un certain seuil, son mur d'isolement est submergé par les porteurs créés et des porteurs vont diffuser dans le caisson adjacent où ils peuvent créer des perturbations. De façon générale, si la densité de porteurs dans un caisson devient excessive par suite de la conduction de composants contenus dans ce caisson, ces porteurs vont se répandre dans le caisson voisin en traversant le mur d'isolement dans sa région la moins épaisse et la moins dopée. En d'autres termes, un mur d'isolement efficace en statique peut ne plus l'être en dynamique.

La solution proposée par la demande de brevet français 97/06822 consiste à former des murs d'isolement de façon que leur partie médiane ait un niveau de dopage suffisant pour constituer une barrière étanche à la diffusion d'électrons d'un caisson à un caisson voisin. Il est spécifié que, en pratique, quand la concentration en atomes dopants au niveau de la partie médiane du mur d'isolement est supérieure à 10¹⁶ atomes/cm³, on évite tout problème dans la majorité des cas, et il est également proposé de jouer sur la largeur de la zone médiane du mur d'isolement. La figure 5 illustre un mur d'isolement ainsi formé. Ce mur est réalisé en poursuivant la diffusion de zones dopées à partir d'ouvertures 55 et 56 pour que les régions diffusées 57 et 58 s'interpénètrent et que le niveau de dopage au niveau de la ligne médiane 59 soit accru.

Cette solution antérieure implique pour une plaquette d'épaisseur donnée, d'augmenter la durée du recuit de diffusion lors de la formation des murs d'isolement et/ou d'augmenter la largeur des murs d'isolement. On en arrive, quand on veut assurer un isolement dynamique élevé entre des caissons distincts tels qu'un courant important est susceptible de circuler dans l'un de ces caissons, à des murs d'isolement qui peuvent avoir des largeurs importantes, supérieures au double de l'épaisseur de la tranche semiconductrice.

Comme on l'a indiqué précédemment, la présente invention vise, d'une part, à augmenter l'efficacité d'isolement dynamique d'un mur d'isolement, d'autre part, à réduire la largeur nécessaire d'un mur d'isolement quand le courant susceptible de traverser un caisson est très intense.

Pour atteindre cet objet, la présente invention propose de former des murs d'isolement de la façon illustrée en figures 6A et 6B.

La figure 6A représente une portion d'une tranche semiconductrice dont la partie gauche est désignée par la référence 61 et dont la partie droite est désignée par la référence 62. Ces parties droite et gauche correspondront chacune à un caisson dans lequel est susceptible d'être formé un composant de puissance haute tension ou fort courant. Selon l'invention, le mur d'isolement est composé de deux murs d'isolement élémentaires, respectivement 63 et 64, séparés par une portion 65 du substrat semiconducteur. La figure 6A indique comment ces murs d'isolement élémentaires sont formés, d'une façon classique similaire à celle décrite en relation avec la figure 4 à travers des ouvertures ménagées dans des masques 67 et 68 respectivement formés sur les faces supérieure et inférieure de la tranche semiconductrice.

Dans une deuxième étape de fabrication, illustrée en figure 6B, on forme des zones surdopées de type N⁺ 71 et 72 respectivement en contact avec la région 65 du côté de la face supérieure et de la face inférieure de la tranche semiconductrice. Ces zones sont solidaires de métallisations respectives 73 et 74. La métallisation 73 est une métallisation spécifique formée sur la région de type N⁺ 71 et de préférence sur les surfaces supérieures des murs 63 et 64. La métallisation 74 est la métallisation qui, de façon habituelle, recouvre l'ensemble de la face arrière d'un composant de puissance. La métallisation 74 est destinée à être connectée à une tension de référence, par exemple la masse. La métallisation 73 est au potentiel de la métallisation 74 du fait de leur connexion par les murs 63, 64.

Selon la présente invention, les murs d'isolement élémentaires 63 et 64 peuvent avoir des dimensions minimum. Ils seront toutefois de préférence diffusés de façon un peu plus profonde que cela n'est classique de façon que leur dopage au niveau de leurs zones médianes dépasse 10⁶ atomes/cm³.

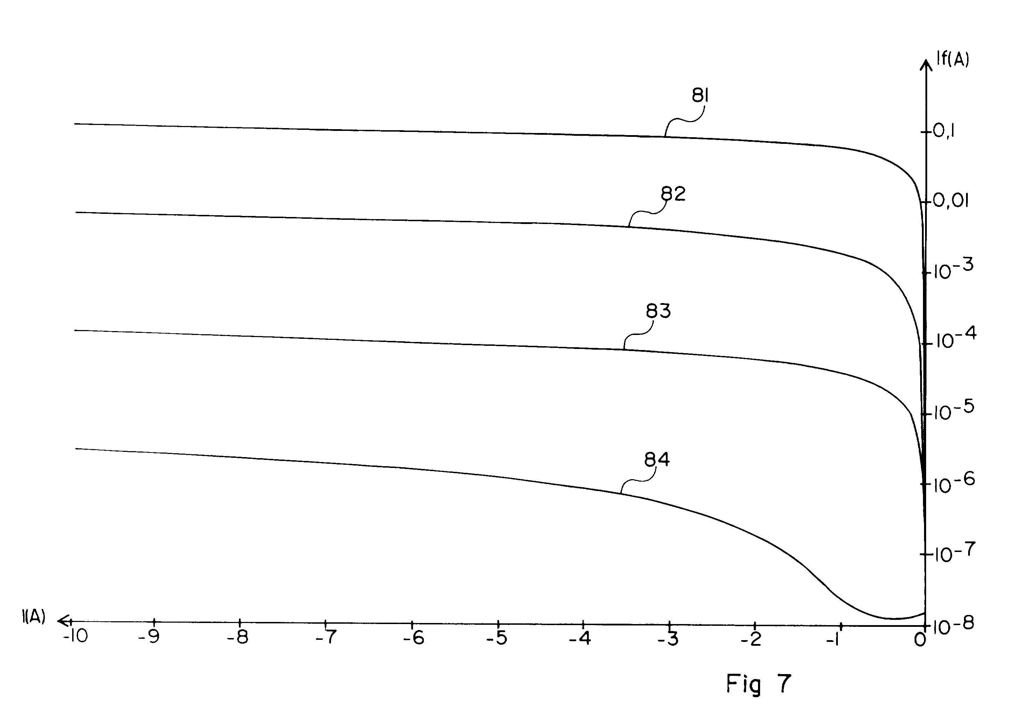

Les caractéristiques d'une structure selon la présente invention ont été comparées aux caractéristiques d'une structure classique, en mesurant le courant de fuite dans un caisson adjacent à un caisson dans lequel on faisait circuler un courant intense d'amplitude déterminée. En figure 7, le courant I dans le premier caisson est indiqué en coordonnées linéaires entre des valeurs de 0 et -10 ampères (le courant est indiqué négativement car il s'agit d'un courant sortant de la structure). On a indiqué en ordonnées, en coordonnées logarithmiques, le courant de fuite If capté dans un caisson voisin.

La courbe 81 correspond à une structure du type de celle de la figure 4 dans laquelle la largeur des ouvertures dans les masques 51 et 52 était de l'ordre de 100 µm et dans laquelle la concentration en atomes dopants au niveau médian du mur était de l'ordre de 5.10¹⁴ at./cm³. On voit que, dès que le courant dans le premier caisson dépasse une valeur de l'ordre de 1 A, le courant de fuite atteint une valeur de l'ordre de 0,1 A.

La courbe 82 correspond au cas d'un caisson selon la demande de brevet français 9706822 dans lequel la largeur des ouvertures 55, 56 était de l'ordre de 200 µm et la concentration au niveau médian de l'ordre de 10¹⁶ atomes/cm³. On voit que, pour des courants supérieurs à -2 A dans un premier caisson, le courant de fuite devient nettement inférieur à 10⁻² A.

La courbe 83 correspond à une configuration similaire à celle de la courbe 82 mais dans laquelle la largeur des ouvertures de diffusion du mur d'isolement était de l'ordre de 400 µm. Alors, le courant de fuite est réduit à une valeur de l'ordre de 10⁻⁴ A.

La courbe 84 correspond à une structure selon la présente invention à mur d'isolement double dans laquelle les ouvertures dans les masques destinés à former les murs d'isolement avaient une largeur de l'ordre de 50 µm et la distance entre les deux murs élémentaires était de l'ordre de 300 µm. Ainsi, la structure dans son ensemble avait un encombrement sensiblement identique à celui de la structure correspondant à la courbe 83. On constate une réduction de l'ordre de 100 du courant de fuite pour des valeurs du courant dépassant 4 A, et des réductions encore beaucoup plus importantes, supérieures à 1000, pour de faibles valeurs du courant.

La présente invention atteint donc bien ses objets à savoir une réduction du courant de fuite et une réduction de dimension d'un mur d'isolement. En effet, pour obtenir un même résultat que celui correspondant à la courbe 84 avec une structure correspondant à la courbe 83, il faudrait augmenter considérablement la largeur de cette dernière structure.

On attribue les avantages de la structure à double mur d'isolement selon la présente invention au fait que les électrons provenant d'un caisson, par exemple le caisson 61, ayant traversé le premier mur d'isolement 63 vont être extraits de la région centrale 65 par les connexions à la masse 73 et 74. Ainsi, très peu d'électrons sont susceptibles de traverser la deuxième partie 64 du mur d'isolement.

La présente invention est susceptible de diverses variantes et modifications qui apparaîtront à l'homme de l'art, notamment en ce qui concerne la nature des composants formés dans les caissons séparés par des murs d'isolement et le nombre de ces caissons.

## Revendications

1. Mur d'isolement du deuxième type de conductivité destiné à séparer des composants élémentaires formés dans des caissons différents d'une tranche semiconductrice d'un premier type de conductivité, un composant situé dans l'un au moins des caissons étant susceptible de fonctionner avec une densité de courant importante, ce mur d'isolement comportant au moins deux murs d'isolement élémentaires (63, 64) séparés par une portion (65) du matériau de ladite tranche, caractérisé en ce que, en fonctionnement, ladite portion est connectée à un potentiel de référence.

2. Mur d'isolement selon la revendication 1, caractérisé en ce que la largeur des ouvertures à partir desquelles sont formées les diffusions de dopants dans les surfaces supérieure et inférieure du substrat est inférieure à la demi-épaisseur du substrat.

3. Mur d'isolement selon la revendication 1 ou 2, appliqué à constituer une séparation entre deux caissons contenant des triacs verticaux.

4. Mur d'isolement selon la revendication 1 ou 2, appliqué à séparer deux caissons dont l'un au moins comprend une diode, un thyristor ou un triac vertical.

5. Mur d'isolement selon l'une quelconque des revendications 1 à 4, dans lequel les divers composants sont de type vertical et la puce semiconductrice comprend une métallisation unique en face arrière.
